# EUROPEAN PATENT SPECIFICATION

(11) **EP 0 419 073 B1**
(45) Date of publication and mention of the grant of the patent: **30.07.1997**
(21) Application number: 90309551.1
(22) Date of filing: 31.08.1990
(51) Int. Cl.: G03F 7/30

(54) **Process for production of a semiconductor device**
Verfahren zur Herstellung einer Halbleitervorrichtung
Procédé pour la production d'un système semi-conducteur

(30) Priority: 20.09.1989 JP 244042/89
(43) Date of publication of application: 27.03.1991
(73) Proprietor: FUJITSU LIMITED, Kawasaki-shi, Kanagawa 211 (JP)
(72) Inventor: Maruyama, Takashi, Setagaya-ku, Tokyo 158 (JP); Chijimatsu, Tatsuo, Kawasaki-shi, Kanagawa 214 (JP); Kobayashi, Koichi, Yokohama-shi, Kanagawa 226 (JP); Yano, Keiko, Eterunamezon Mizoguchi 203, Kawasaki-shi, Kanagawa 213 (JP); Kanata, Hiroyuki, Fujitsu Nakahara Hausu W-8, Kawasaki-shi, Kanagawa 211 (JP)
(74) Representative: Silverman, Warren

(56) References cited:
- FR-A- 2 284 907
- PATENT ABSTRACTS OF JAPAN vol. 13, no. 272 (E-377)(3620) 22 June 1989, & JP-A-1 61915 (HITACHI LTD) 08 March 1989
- PATENT ABSTRACTS OF JAPAN vol. 8, no. 68 (P-264)(1505) 30 March 1984, & JP-A-58 214151 (HITACHI SEISAKUSHO KK)
- PATENT ABSTRACTS OF JAPAN vol. 6, no. 28 (E-95)(906) 19 February 1982, & JP-A- 56 148831 (NIPPON DENKI KK)

## Description

The present invention relates to a process for the production of a semiconductor device. More particularly, the present invention relates to a process for the high precision formation of a resist pattern valuable for use as a mask in selectively etching a semiconductor substrate, silicon oxide film or polycrystalline film (generally called "workpiece" hereinafter) or in injecting ions into the workpiece in the production of a semiconductor device such as an LSIS. Namely, the present invention relates to an improvement in the resist-forming process, and the development process for forming a resist.

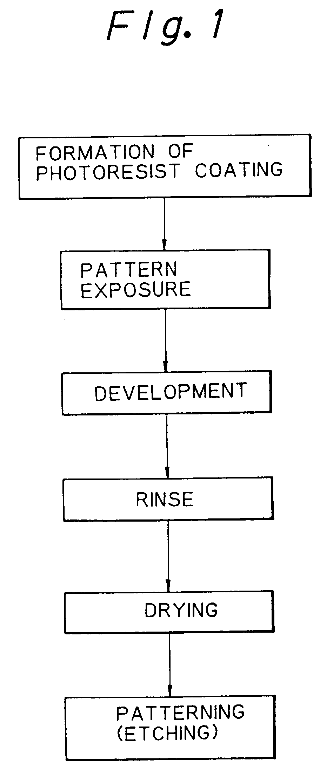

In the formation of a semiconductor device, the patterning of a silicon oxide film, a polycrystalline silicon film, an aluminum film or the like is carried out by etching, and a photoresist material (photosensitive resin material) having a high resolution, high etching resistance, and high sensitivity is used for fine patterning operations. In general, patterning of a workpiece, such as a silicon oxide film, is conducted according to the steps shown in Fig. 1 of the accompanying drawings which is a flow diagram of a conventional pattern-forming method. Namely, first a photoresist film is formed on the workpiece. Negative-working photoresist materials suitable for use for this purpose are, for example, polymeric materials such as a polystyrene or rubber-type material. The photoresist material is coated on the workpiece by spin coating to form a photoresist film, and the formed photoresist film is then exposed to a pattern of light to which the photoresist material is sensitive, whereby a latent image corresponding to this pattern is formed in the photoresist film. Where the exposure light source uses ultraviolet rays, patterning is effected by placing a mask having a predetermined pattern on the photoresist film and exposing the entire surface to exposure light. Where the exposure light source uses high-energy radiation, such as an electron beam (EB), patterning exposure is carried out directly by using an EB exposure apparatus. After the patterning exposure, the exposed photoresist film is developed. Development is carried out, for example, by immersing the workpiece in a liquid developer such as an organic solvent, for example comprising esters and alcohols, or an aqueous alkali solution. As a result of this development, the unexposed area is dissolved and removed, and thus a negative resist pattern is obtained. In the usual resist-forming process, rinsing is generally carried out for removing the adhering liquid developer, followed by drying. Then, the workpiece as the substrate is selectively etched by using the obtained resist pattern as a mask. This etching is performed by the dry process or the wet process according to the characteristics of the photoresist material. Thus, a desired resist pattern can be formed on the workpiece through the above-mentioned process steps.

Nevertheless, this conventional resist-patterning process is defective in that, in some resist processes, development is attained only with the use of an organic solvent as a developer. In such processes, if it is intended to conduct a fine patterning of resist, a deformation or shift occurs in the obtained resist pattern. These problems will now be described with reference to Figures 2A-2E of the accompanying drawings which are diagrammatic sectional views of a workpiece undergoing a known resist-patterning process using a negative photoresist material.

First, as shown in Fig. 2A, a negative photoresist material is coated on a film 40 to be processed (aluminum film in this case), which is formed on a semiconductor (silicon) substrate 50, by a spin-coating method, to form a photoresist film 41. The photoresist material used is chloromethylated polystyrene, and the thickness of the formed photoresist film is 1.5 µm.

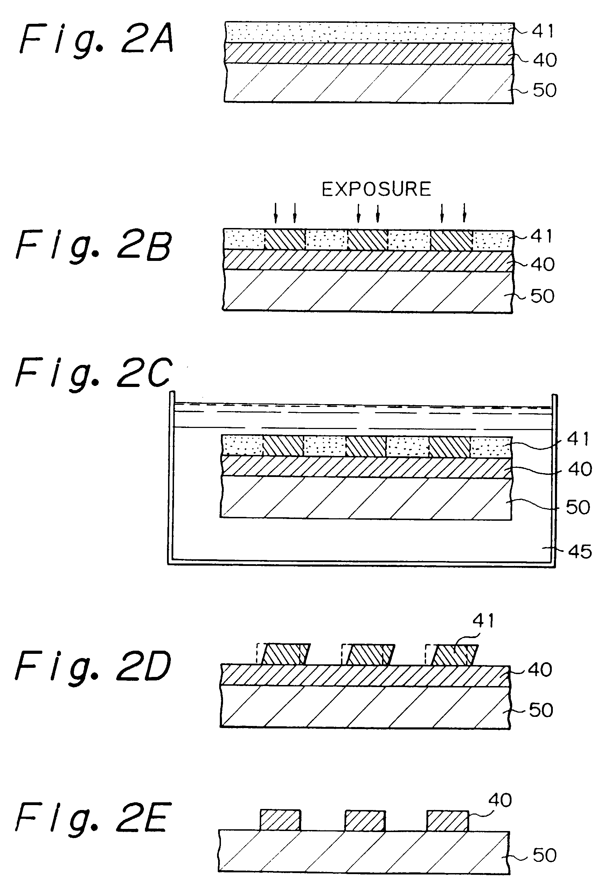

Then, as shown in Fig. 2B, patterning exposure is carried out at 1 µm-line and 1 µm-space by using an electron beam as the light source. This light exposure causes the photoresist film 41 of the exposed region to be insoluble by the liquid developer to be used in the next step.

After the patterning exposure, as shown in Fig. 2C, the workpiece is immersed in a liquid developer and the photoresist film 41 of the unexposed region is dissolved and removed. The liquid developer used is a mixture of isoamyl acetate and ethyl cellosolve (9:1).

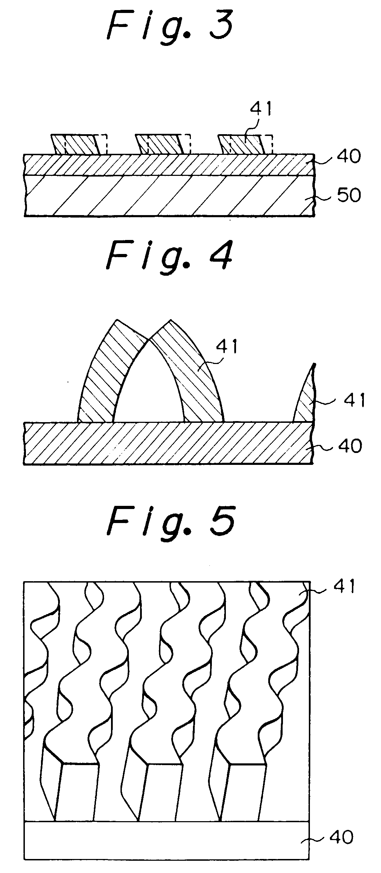

Then, the workpiece is removed from the liquid developer and is rinsed and dried (not shown in the drawings), whereby a negative resist pattern 41 is obtained as shown in Fig. 2D. In principle, the resist pattern should be formed at the position indicated by the dotted lines, but, because of a meandering caused by swelling of the resist material, the resist pattern 41 is shifted to the right and is inclined. From experiments carried out by the inventors, it has been confirmed that the shift of the resist pattern 41 is about 0.3 µm at the lower end and about 0.5 µm at the upper end. In some cases, the resist pattern 41 is caused to shift to the left and is inclined, as shown in Fig. 3 of the accompanying drawings, or, when the aspect ratio of the resist pattern 41 is large, as shown in Fig. 4 of the accompanying drawings, shoulders of adjacent patterns overlap each other. The shift and wavy deformation of the resist pattern 41 shown in Fig. 2D will become more apparent from the perspective view of Fig. 5 of the accompanying drawings.

If the film 40 to be processed is etched by using this defective resist pattern as a mask, the film 40 is patterned only in the meandering state with a shift of about 0.3 µm, as shown in Fig. 2E, and the presence of this defect results in a reduction of the yield of the final product.

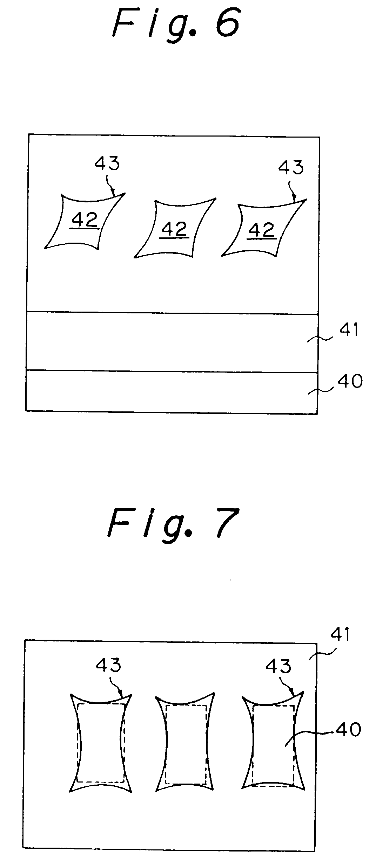

In the conventional resist-patterning process using a positive photoresist material, such as polymethacrylate, because the pattern-left area is large, the problem of formation of cracks on the pattern edge often arises, due to a swelling of the resist with an organic solvent. More specifically, where a rectangular window 42, indicated by dot lines in Fig. 7 of the accompanying drawings, is opened in the positive photoresistive film 41 on the film 40 to be processed, deformation of the window is caused by swelling of the resist resin, and cracks 43 are formed on the pattern edge, as shown in Fig. 6 of the accompanying drawings.

Some techniques concerning improvements in the developing process are known, but they are essentially different from the present invention and do not contribute to the completion of the present invention. For reference, these techniques will now be briefly discussed.

The invention disclosed in Japanese Unexamined Patent Publication (Kokai) No. 63-233530 relates to a pattern-forming process, in particular a pattern-forming process valuable for obtaining an overhanging photoresist by the lift-off process. According to this invention, development using an alkali liquid developer is once interrupted, the liquid developer is washed and removed with pure water, and development is conducted again with the same liquid developer. If development is thus interrupted, even when the development-interrupted portion is subjected to another development, the development speed is lower than the usual development speed, and accordingly, the desired overhanging pattern can be easily formed.

The invention disclosed in Japanese Unexamined Patent Publication (Kokai) No. 64-61915 also relates to a pattern-forming process. According to this invention, in the process where a positive resist film is light-exposed, developed, water-washed and dried, the operation of reducing the developing speed on the surface of the positive resist or on the surface of the new resist formed by the development is repeated a plurality of times during development using an alkali liquid developer, or before and during the development. Water washing and drying after the interruption of development are effective as the means for reducing the developing speed. If the developing speed of the region not irradiated with electron beams is thus reduced, the proximity effect is reduced and a pattern having a high dimensional precision and a high contrast can be formed.

Nevertheless, it should be noted that, since the pattern-forming processes described in above-mentioned Japanese Kokais do not use an organic solvent as a developer, they cannot avoid the problem of resist swelling.

With regard to the problem of resist swelling, this swelling can, of course, be controlled by changing the composition of the liquid developer or the developing temperature, or by changing the composition of the photosensitive polymer used as the photoresist. However, a satisfactory effect cannot be obtained. Therefore, the development of a process for the production of a semiconductor device in which, when developing a latent image of a photoresist film, the visualization is accomplished at a high precision and a film to be processed can be patterned by using the formed photoresist film as a mask, is desired.

An object of the present invention is to provide a process for the production of a semiconductor device in which a resist pattern can be formed at a high precision without a deformation or shift of the resist pattern or a formation of cracks on the pattern edge.

In accordance with the present invention, there is provided a process for the production of a semiconductor device, comprising the steps of:
coating an article to be fabricated with a resist material to form a resist coating thereon;
exposing the resist coating to a predetermined pattern of radiation to form a latent image in the resist coating corresponding to the pattern of radiation;
developing the exposed resist coating with an organic solvent developer to form a resist pattern corresponding to the pattern of radiation on the article; and
selectively fabricating the article by using the resulting resist pattern as a mask,
wherein said developing step is carried out in at least two development stages, each development stage comprising: developing the exposed resist coating with an organic solvent developer; and interrupting development when the organic solvent developer has substantially permeated a surface portion of the exposed resist coating by drying the developed resist coating, thereby preventing said organic solvent developer from permeating further into the resist film.

The process of the present invention can be used in the formation of either a positive resist pattern or a negative resist pattern; whether a positive resist pattern or a negative resist pattern is formed depends on the resist material to be used. As described hereinafter, an optional resist material may be appropriately selected from a variety of resist materials according to desired results and other factors. Moreover, the resist materials to be used in the invention can have a sensitivity to light from various light sources, and in the present specification, the word "light" or "radiation" is used in a broad sense, and a variety of light sources ranging from high-energy radiant light such as electron beams and ion beams to X-rays and ultraviolet rays can be used.

According to the present invention, by repeating the operations of supplying an organic solvent liquid developer to a resist film having a latent image formed by light exposure and drying the resist film slightly impregnated with the liquid developer in sequence, the resist film is intermittently patterned to effect visualization of the latent image. Therefore, the intrusion of the organic solvent liquid developer can be confined to the surface layer portion of the resist film, and the liquid developer is prevented from permeating deep into the resist film. The result is that deformation and other defects due to swelling of the resist film can be minimized or prevented in the formed pattern, and thus the development precision can be increased.

For a better understanding of the invention and to show how the same may be carried into effect reference will now be made, by way of example only, to the accompanying drawings, in which:
Figure 1 is a flow diagram illustrating steps in a conventional resist-patterning process;
Figs. 2A to 2E are diagrammatic sectional views of a workpiece illustrating steps in a conventional negative resist-patterning process;
Figs. 3 and 4 are diagrammatic sectional views of a workpiece showing defects in the conventional negative resist-patterning process;
Fig. 5 is a diagrammatic perspective view of a workpiece illustrating defects in the conventional negative resist-patterning process;
Figs. 6 and 7 are diagrammatic perspective and plane views of a workpiece illustrating defects in the conventional positive resist-patterning process;
Fig. 8 is a graph illustrating the relationship between development time and thickness increasing ratio in a photoresist film;
Fig. 9 is a flow diagram illustrating a resist-patterning process in accordance with the present invention;
Figs. 10A to 10H are diagrammatic sectional views of a workpiece illustrating steps of one embodiment of the present invention;
Figs. 11, 12, 13 and 14 are diagrammatic perspective views illustrating resist films developed by methods in accordance with the present invention;
Figs. 15A to 15H are diagrammatic sectional views of a workpiece illustrating steps of another embodiment in accordance with the present invention;
Fig. 16 is a sectional view illustrating a developing apparatus for use in working the method of the present invention; and
Fig. 17 is a graph illustrating the relationship between the molecular weight of the resist material and the standard value of the development time of one cycle.

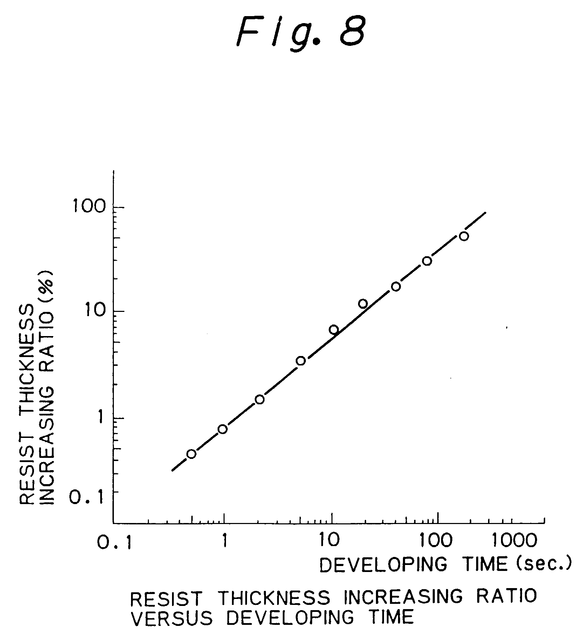

In view of the close relationship between the swelling of the photoresist material and the developing step, the inventors carried out experiments with a view to clarifying the relationship between the developing time and the thickness increasing ratio of the photoresist film. The results plotted in the graph of Fig. 8 were obtained. The relationship between the film thickness-increasing speed of a negative electron beam resist, i.e. chloromethylated polystyrene, and the developing time was measured by detecting change in intensity of the reflected light. The initial resist film thickness was 1.64 µm and the electron beam dose was 35 µC/cm2. The resist film thickness increased with an increase in the development time and, when development was conducted for 200 seconds, the thickness increased to 180% of the initial film thickness. Based on this finding, investigations were made with a view to shortening the development time, and as a result, the present invention was completed.

According to the present invention, after a latent image is formed by the light exposure of a resist film, the operations of supplying a liquid developer to the resist film and drying the resist film slightly impregnated with the liquid developer are repeated several times in succession, whereby the resist film is intermittently patterned and the latent image is visualized.

Accordingly, the penetration of the liquid developer is confined to the surface layer of the photoresist film. Deep permeation of the liquid developer can be controlled and deformation of the resist pattern by swelling is reduced, with the result that the development precision can be increased.

In the present invention, the step of removing the liquid developer by rinsing can be interposed between the developing and drying steps, according to need, and an embodiment in which these three steps are repeated a plurality of times in sequence is included within the scope of the present invention.

According to the present invention, especially prominent effects can be attained when a crosslinking resist is used which swells greatly in a liquid developer, and prominent effects are attained when an organic solvent is used as the liquid developer and a crosslinking photosensitive polymer is used as the resist material. By "crosslinking resist material" is meant a resist material in which a pattern is formed based on the difference of the dissolution owing to the difference of the crosslinking degree.

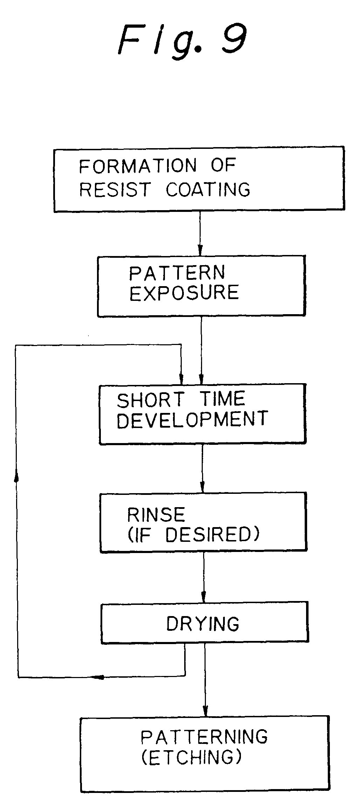

Steps in a process for the production of a semiconductor device according to the present invention, especially the resist-patterning process, are shown in Fig. 9.

First, a resist material is coated on a workpiece (or a film to be processed) to form a resist film. A photosensitive polymer is preferably used as the resist material. Preferred examples of the photosensitive polymer are polystyrene, polysiloxanes, polyacrylates, polymethacrylates, cyclized rubbers, polyvinyl cinnamate, polysulphones, other crosslinking polymers and derivatives thereof. The spin coating method is advantageously adopted for coating the resist material, but other customary coating methods can be adopted if desired. The molecular weight of the photosensitive polymer advantageously used in the present invention, especially the photosensitive crosslinking polymer, can be within a broad range, but is preferably about 1,000 to about 1,000,000.

The formed resist film is then exposed to light or radiation of a predetermined pattern. When electron beams are used as the light source, an electron beam exposure apparatus can be used, and when X-rays or ultraviolet rays are used as the light source, the patterning exposure can be carried out by using a photo-mask.

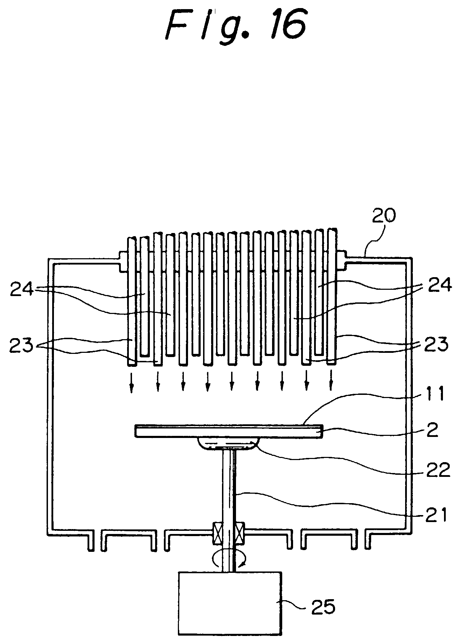

After the patterning exposure is completed, the cycle of short-time development and drying is repeated according to the present invention and, if necessary, rinsing can be conducted between development and drying. In the present invention, the short-time development is conducted at least twice. At each stage, development is stopped when the liquid developer permeates substantially only the surface layer portion of the pattern-forming region to be left as the resist pattern in the resist film. At each stage, development is carried out for a time shorter than the time required for the swelling of the photosensitive polymer in the pattern-forming region of the resist film to become saturated. In the present invention, development and rinsing (conducted according to need) can be performed by using various devices. However, development and rinsing is preferably carried out in a system where many nozzles for supplying a liquid developer and/or a rinsing liquid are arranged, as explained hereinafter with reference to Fig. 16, and developer supply nozzles 23 and rinsing liquid supply nozzles 24 are disposed alternately in such a manner that they are opposed to a semiconductor substrate 2.

According to the present invention, by conducting the short-time development and drying repeatedly and intermittently as described above, the occurrence of problems such as shift and wavy deformation of the resist pattern and a formation of cracks can be prevented.

After the completion of the series of developing operations, the workpiece is selectively processed (subjected to etching or injection of ions) by using the obtained resist pattern as a mask. Since the resist pattern has a high precision and excellent characteristics such as resolving power, sensitivity and dry etching resistance, a satisfactory processing is possible.

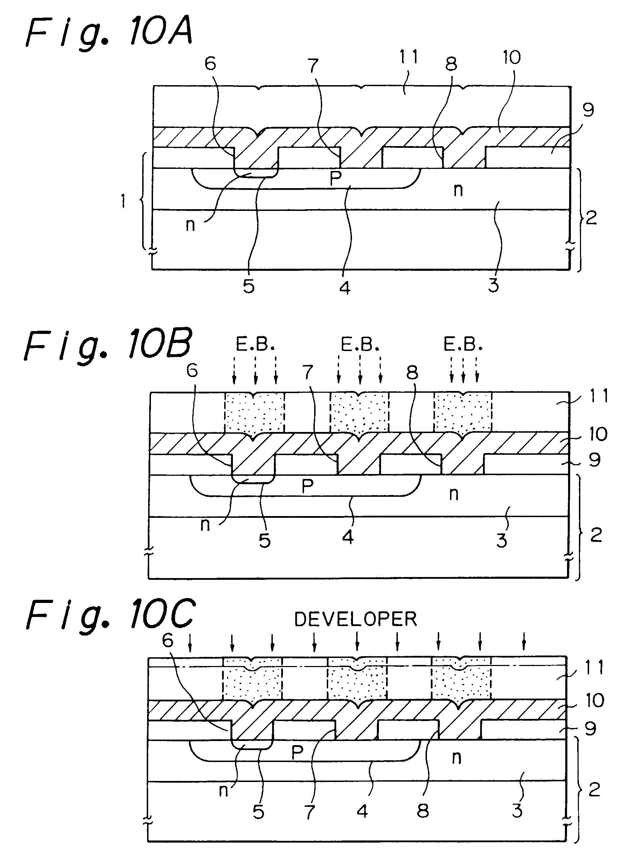

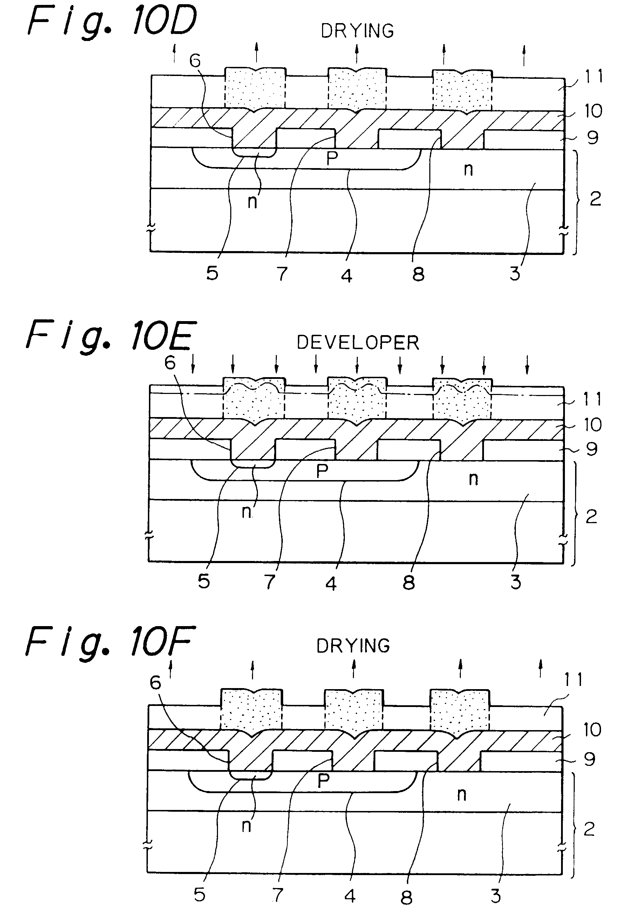

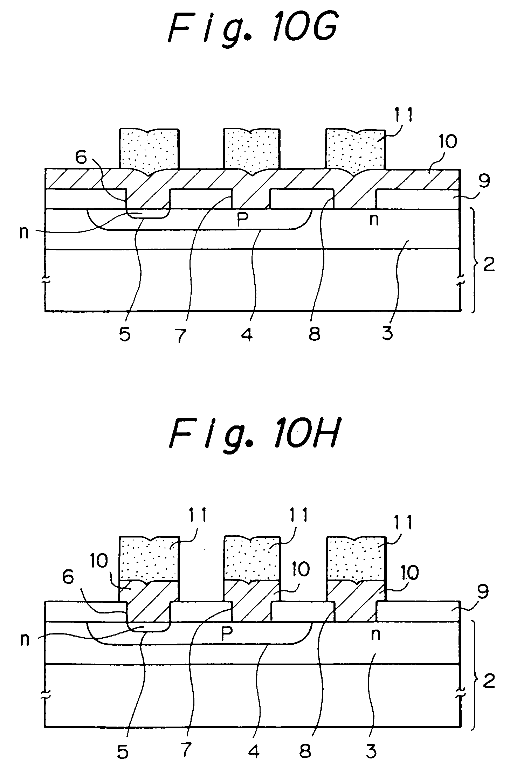

When a negative resist material is used, the process of the present invention is conducted according to procedures shown in sectional views of Figs. 10A to 10H. In the drawings, reference numeral 1 represents a bi-polar transistor (bulk) formed on a semiconductor substrate 2. This bi-polar transistor 1 comprises a p-type collector layer 3, a p-type base layer 4 formed on the surface portion of the collector layer 3 and an n-type emitter layer 5 formed on the surface portion of the base layer 4. An interlaminar insulating film 9 composed of SiO₂ is formed on the bi-polar transistor 1, and an emitter window 6, a base window 7 and a collector window 8 are formed in the film 9 to expose the emitter layer 5, the base layer 4 and the collector layer 3, respectively.

Reference numeral 10 represents an aluminum film to be patterned by means of the steps described below, i.e., a film to be processed. Aluminum film 10 is laminated to cover the interlaminar insulating film 9 and fill the interiors of the emitter window 6, base window 7, and collector window 8.

In this state, a negative resist material composed of chloromethylated polystyrene is coated on the aluminum film 10 by the spin coating method to form a resist film 11 having a thickness of 1.2 µm (see Fig. 10A).

The aluminum film 10 in the region to be left, i.e., in the portions located on the emitter window 6, base window 7, and collector window 8 and surrounding portions, is irradiated with electron beams to form a latent image in the resist film 11. At this step, the irradiation with electron beams is carried out, for example, under conditions of 30 kV and scores of µC/cm2 (see Fig. 10B).

The semiconductor substrate 2 is then placed in a development chamber 20, as diagrammatically illustrated in Fig. 16, and the back surface of the semiconductor substrate 2 is fitted to a suction panel 22 arranged on the top end of a vacuum chuck 21 disposed in the development chamber 20 to fix the semiconductor substrate 2 by suction, so that the resist film 11 faces a plurality of liquid developer supply nozzles 23 and rinsing liquid supply nozzles 24 arranged in parallel.

The vacuum chuck 21 is rotated by a driver 25 and a liquid developer is jetted onto the resist film 11 from the developer supply nozzles 23 (see Fig. 10C). The liquid developer used at this step can be a liquid mixture containing acetone and isopropyl alcohol (4:1), or a solution containing ethyl cellosolve and isoamyl acetate (1:9).

The supply of liquid developer is continuously conducted for a short time and then a rinsing liquid of isopropyl alcohol (IPA) is supplied to the resist film 11 for about 5 seconds, from the rinsing liquid supply nozzles 24, to wash away the liquid developer adhering to the resist film 11. Then the liquid developer 11, which has slightly permeated the surface layer portion of the resist film 11, is evaporated by an air current generated by the rotation of the substrate to effect drying. In this case, the rotation speed of the vacuum chuck 21 is adjusted from several hundred rpm to several thousand rpm.

The above-mentioned development, rinsing, and drying treatments are repeated scores of times or several hundred times, whereby the photoresist film 11 is intermittently developed while preventing the liquid developer from deeply permeating the resist film 11, and the latent image is visualized without deformation, exceeding the allowable range, of the pattern of the latent image (see Figs. 10C to 10G).

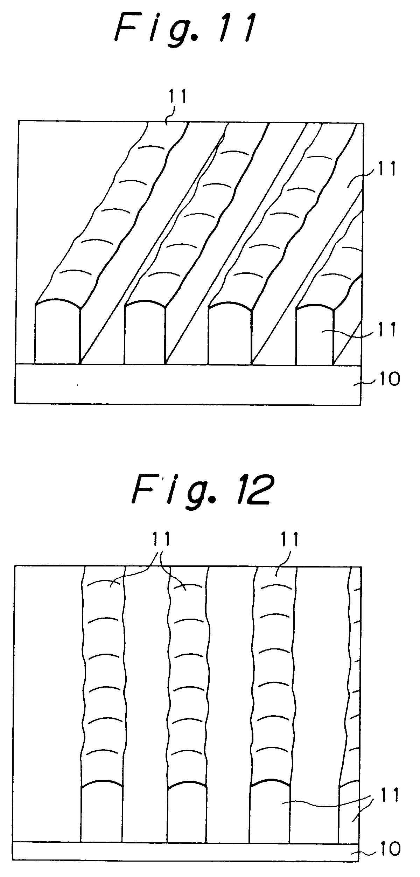

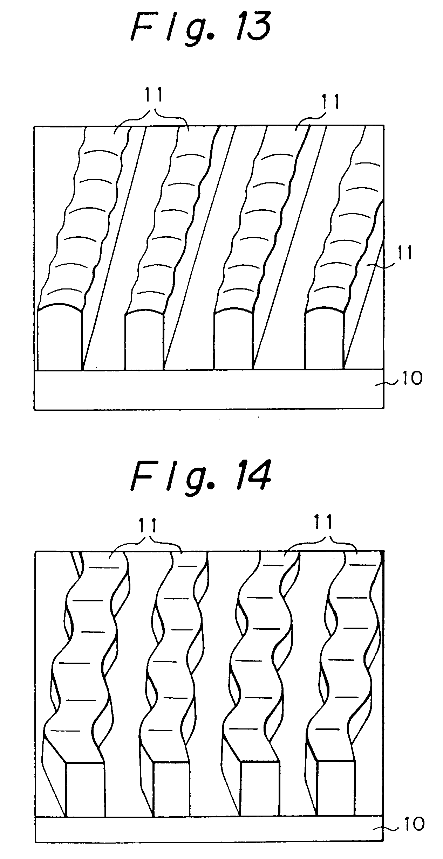

By way of example, the development time, rinsing time, and drying time are adjusted to 0.2 second, 5 seconds, and 5 seconds, respectively. 125 cycles of these treatments are carried out so that the total development time is 25 seconds, whereby the development of the resist film 11 is effected and a plurality of stripe patterns having a thickness of 1.2 µm and a width of 0.7 µm are formed. Thus, the resist film 11 is developed in the state shown in Fig. 11 and a pattern having no deformation is formed. If the development time is adjusted to 0.5 second and the development, rinsing and drying treatments are repeated 50 times in the above-mentioned manner, a pattern having no substantial deformation is obtained, as shown in Fig. 12. If the development time is adjusted to 1.0 second and the development, rinsing and drying treatments are repeated 25 times, a slight deformation of the pattern is caused, as shown in Fig. 13. If the development time is adjusted to 2 seconds and the development is carried out 12 times intermittently, a wavy deformation is caused in the formed pattern, as shown in Fig. 14, and it is confirmed that the deformation is large in this case.

From the foregoing experimental results it is clarified that, when the development time of one cycle is increased, the degree of deformation of the pattern increases. This is considered to be because, if the development time is long, the resist film 11 absorbs the liquid developer and is consequently swollen resulting in deformation of the pattern. It is confirmed that the deformed pattern cannot be restored to the original pattern even if drying is conducted afterwards.

The molecular weight of the chloromethylated polystyrene used as the resist material in the foregoing embodiment is about 7,200. If the development time of one cycle is adjusted to about 0.5 second and the development, rinsing and drying treatments are repeated in sequence a plurality of times, development is accomplished without any substantial deformation of the pattern.

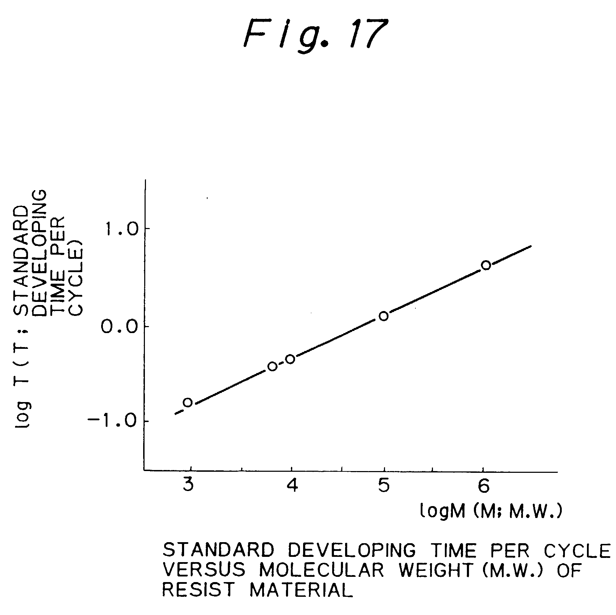

The relationship between the development time of one cycle not causing deformation of the pattern and the molecular weight of the polymer material used for the resist film 11 is illustrated in Fig. 17. Accordingly, by deciding the etching time of one cycle according to the molecular weight and conducting development for the so-decided development time, a resist mask having a high precision can be formed.

Note, the speed of diffusion of the solvent in the polymer is substantially represented by the formula of S = 50 M^{-0.45} µm/sec (quoted from J. Polymer Sci., 57, 187, 1962; this formula indicates a diffusion of toluene in polystyrene and M in the formula represents the molecular weight). The results shown in Fig. 17 are derived in due consideration of this diffusion speed.

For example, if the molecular weight is 7200, S is equal to 0.9 µm/sec, and the development time of 0.5 second corresponds to the liquid developer intrusion depth of about 0.45 µm. The development time allowing this intrusion depth (0.45 µm) is determined with respect to each molecular weight, and the obtained results are plotted in Fig. 17. Since the intrusion speed is reduced with an increase of the molecular weight (0.2 second at a molecular weight of 1,000, 0.57 second at a molecular weight of 10,000, 1.6 seconds at a molecular weight of 100,000 and 4.5 seconds at a molecular weight of 1,000,000), if the molecular weight is high, a longer liquid developer supply time per cycle is allowed.

If development is carried out intermittently for a step time shorter than the standard time shown in Fig. 17, a good pattern can be obtained. Moreover, the necessary step time depends on the thickness of the resist film. Preferably the step time is set at a value smaller than the time allowing an intrusion of the liquid developer into the resist film along a depth corresponding to 1/3 of the thickness of the resist film. For example, in the above embodiment, the step time is set at 1 second in the case of a resist film having a thickness of 2.4 µm, and at 0.25 second in the case of a resist film having a thickness of 0.65 µm.

The development, rinsing, and drying operations are thus repeated a plurality of times, and the developed resist film 11 is used as a mask at the subsequent processing step. The underground aluminum film 10 exposed from the patterned resist film 11 is wet-etched with a phosphorous acid-containing liquid or the like or is dry-etched with a chlorine-containing gas, whereby an aluminum printed pattern for an electrode is formed on the semiconductor substrate 2 (see Fig. 10H).

In the foregoing embodiment, development of the resist film 11 is effected through the development, rinsing and drying treatments. Nevertheless, in general, swelling of the resist film can be prevented by repeating the development and drying treatments, if the developer used has a low boiling point and a high volatility. The fundamental feature of the present invention resides in the repetition of the development and drying treatments.

In the foregoing embodiment, a patterning exposure of the resist film 11 is performed with electron beams, but the patterning exposure can also accomplished by using ion beams or with X-rays or light by using a photo-mask.

Chloromethylated polystyrene (CMS) is used as the resist material in the foregoing embodiment and this resist material is developed with a liquid mixture of acetone and isopropyl alcohol. Examples of other resist materials that can be used are mentioned below.

Chloromethylated polydiphenylsiloxane (SNR) and polymethylsylsesquioxane (PMSS) can be used and resist films formed therefrom are developed with a ketone type solvent such as methylisobutylketone (MIBK) or methylethylketone (MEK) or an ester type solvent such as ethyl acetate. A resist film formed from a resist material such as polydiallyl o-phthalate (PDAOP) is developed with a liquid mixture of monochlorobenzene and isoamyl acetate. Polyglycidyl methacrylate (PGMA) and a glycidyl methacrylate/ethyl acrylate copolymer (COP) can be used as the resist material and resist films of these materials are developed with acetone and isopropyl alcohol. In each case, if the development and drying treatments are intermittently carried out a plurality of times, the development can be accomplished without swelling of the resist pattern.

When a cyclized rubber type resist material, a polyvinyl cinnamate type resist material, a styrene type resist material, an acrylic resist material, a silicone type resist material, and other crosslinking resist materials are used for the formation of masks, the above-mentioned resist-patterning process can be similarly applied.

The process of the present invention is also effective for preventing cracking when a positive resist material is used.

More specifically, the process of the present invention is especially effective for preventing cracking at the development of positive resist materials such as polymethyl methacrylate (PMMA)-co-methacrylic acid and polymethyl methacrylate (PMMA)-co-methacrylic chloride in the resist-patterning process.

For example, in the usual development process in which development is conducted for 20 seconds and rinsing is conducted for 10 seconds in sequence on a rotated wafer by the spray method, cracking occurs in the foregoing positive resist materials if the thickness exceeds 1.7 µm. In contrast, if the foregoing positive resist materials are developed by repeating the operation cycle of development for a step time of 0.5 second, 5 seconds' rinsing, and 5 seconds' drying (high-speed spin drying at 2000 rpm) 40 times, cracking does not occur even if the thickness is larger than 2 µm. In this embodiment, a 1/1 liquid mixture of methylisobutylketone and ethyl acetate is used as the liquid developer and isopropyl alcohol is used as the rinsing liquid.

An embodiment in which the above-mentioned process is applied to polychloromethylated polystyrene having a molecular weight of 100,000 will now be described. In this embodiment, a resist film of polychloromethylated polystyrene which has a thickness of 1.0 µm is developed at a pattern width of 1.0 µm in a line-and-space stripe pattern in the same manner as described above. Since the diffusion rate S defined by the above-mentioned formula is about 50 M^{-0.45}, if the molecular weight is 100,000, the intrusion speed of the liquid developer is 0.28 µm/sec. Accordingly, the time required for the liquid developer to intrude into the resist film to a depth corresponding to about 1/3 of the film thickness is about 1.2 seconds. The step development time is adjusted to 1 second, the rising time is adjusted to 5 seconds, and the drying time is adjusted to 5 seconds, and these treatments are repeated 20 times as a whole, whereby a good pattern having no substantial deformation is obtained. A 9:1 liquid mixture of isoamyl acetate and ethyl cellosolve is used as the liquid developer, and IPA (isopropyl alcohol) is used as the rinsing liquid. The drying is carried out under a high rotation (4000 rpm). When the step development time is changed to 1.5 seconds and development is repeated 13 times, a slight deformation of the pattern is caused. If development is continuously carried out for 20 seconds, conspicuous meandering and deformation of the pattern are caused by a swelling of the resist film.

As is apparent from the foregoing description, even if the construction is changed by appropriately adjusting the short development time, deformation of the pattern by swelling can be minimized and a good pattern can be obtained.

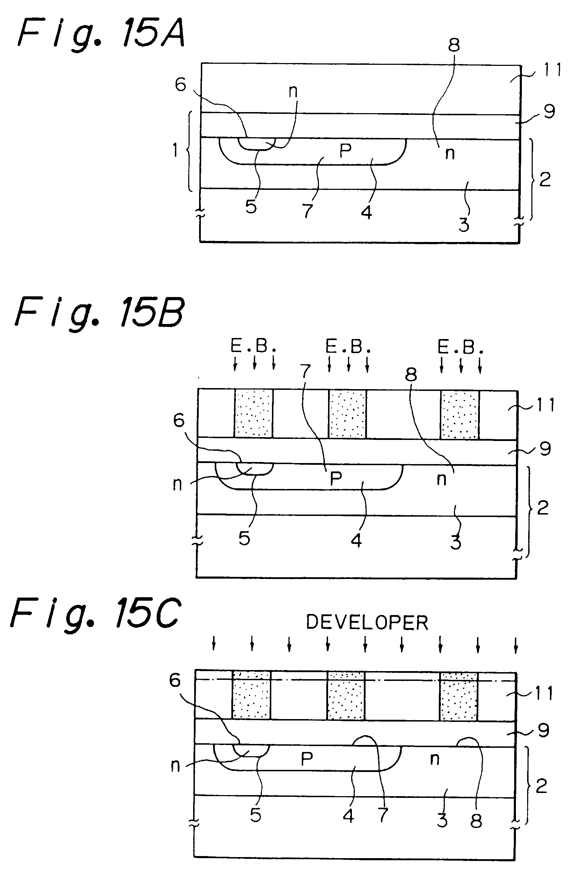

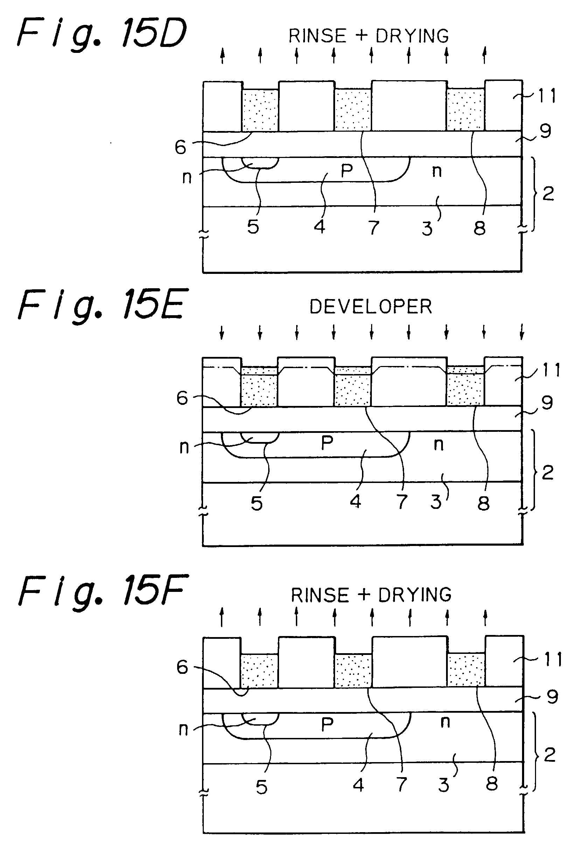

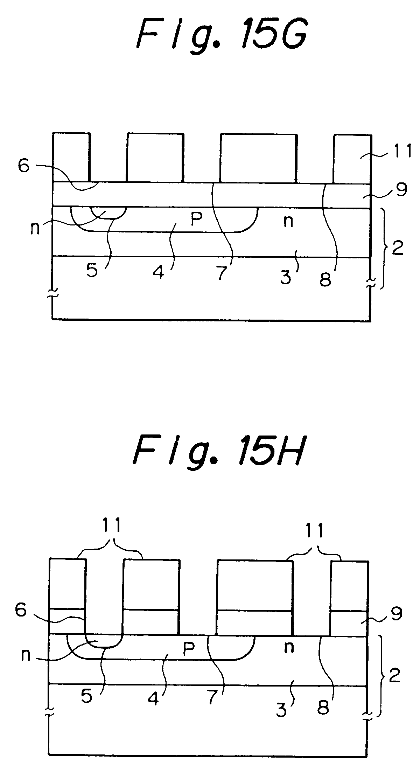

A process in accordance with the present invention using the above-mentioned positive resist material will now be described with reference to Figs. 15A to 15H. The steps shown in Figs. 15A to 15H are the same as those shown in Figs. 10A to 10H, described in detail hereinbefore, except that a positive resist material is used instead of the negative resist material, a rinsing treatment is carried out in addition to the drying treatment, and an interlaminar insulating film 9 is used instead of the aluminum film 10 as the film to be processed. Accordingly, a detailed explanation of these steps is not required but, as is obvious, the series of these operations prevents the formation of cracks on the pattern edge.

In the process of the present invention, not only aluminum but also a silicon oxide film, silicon, chromium, a polymer, PSG, high-melting-point metals such as tungsten and tantalum, and gold can be used as the film to be processed. In the foregoing embodiments, electrodes are formed, but other patterns can be similarly prepared according to the process of the present invention.

The process of the present invention is especially effective when a resist material showing a large swelling in the liquid developer is used. Especially prominent effects can be obtained when a crosslinking resist material is used as the resist material (by "crosslinking resist material" is meant a resist material in which a pattern is formed based on a difference of dissolution caused by a difference of the crosslinking degree).

## Claims

1. A process for the production of a semiconductor device, comprising the steps of:
coating an article (10) to be fabricated with a resist material to form a resist coating (11) thereon;
exposing the resist coating (11) to a predetermined pattern of radiation to form a latent image in the resist coating (11) corresponding to the pattern of radiation;
developing the exposed resist coating (11) with an organic solvent developer to form a resist pattern corresponding to the pattern of radiation on the article (10); and
selectively fabricating the article (10) by using the resulting resist pattern as a mask,
wherein said developing step is carried out in at least two development stages, each development stage comprising: developing the exposed resist coating (11) with an organic solvent developer; and interrupting development when the organic solvent developer has substantially permeated a surface portion of the exposed resist coating by drying the developed resist coating, thereby preventing said organic solvent developer from permeating further into the resist film.

2. A process as claimed in claim 1, characterized in that the resist material is a radiation-sensitive polymer, the development being interrupted in each development stage before the developer has permeated into the exposed resist coating to a depth which is 1/3 of the thickness of the resist coating.

3. A process as claimed in claim 2, characterized in that the radiation-sensitive polymer is selected from polystyrene, polysiloxane, polyacrylate, polymethacrylate, cyclic rubber, polyvinyl cinnamate, polysulphone and other crosslinkable polymers and derivatives thereof.

4. A process as claimed in any one of claims 1 to 3, characterized in that the resist material is a negative resist material such that a negative resist pattern is formed.

5. A process as claimed in any one of claims 1 to 3, characterized in that the resist material is a positive resist material such that a positive resist pattern is formed.

6. A process as claimed in any one of claims 1 to 5, characterized in that each development stage further comprises rinsing the developed resist coating (11) of organic solvent developer with an organic solvent liquid rinsing solution before drying the developed resist coating (11).

7. A process as claimed in any one of claims 1 to 6, characterized in that at least one of the development stages is carried out using a system containing multiple nozzles for applying said developer and an organic solvent liquid rinsing solution to the resist coating (11).

8. A process as claimed in any one of claims 1 to 7, characterized in that, in the fabrication step, the article is selectively etched by using the patterned resist coating as the mask.

## Patentansprüche

1. Prozeß für die Produktion einer Halbleitervorrichtung, mit den folgenden Schritten:
Beschichten eines Artikels (10), der herzustellen ist, mit einem Resistmaterial, um auf ihm eine Resistschicht (11) zu bilden;
Belichten der Resistschicht (11) mit einem vorbestimmten Strahlungsmuster, um in der Resistschicht (11) ein latentes Bild zu bilden, das dem Strahlungsmuster entspricht;
Entwickeln der belichteten Resistschicht (11) mit einem Entwickler aus einem organischen Lösungsmittel, um ein Resistmuster zu bilden, das dem Strahlungsmuster auf dem Artikel (10) entspricht; und
selektives Herstellen des Artikels (10) unter Verwendung des resultierenden Resistmusters als Maske,
bei dem der Entwicklungsschritt in wenigstens zwei Entwicklungsstufen ausgeführt wird, wobei jede Entwicklungsstufe umfaßt: Entwickeln der belichteten Resistschicht (11) mit einem Entwickler aus einem organischen Lösungsmittel; und Unterbrechen der Entwicklung, wenn der Entwickler aus dem organischen Lösungsmittel einen Oberflächenabschnitt der belichteten Resistschicht im wesentlichen durchdrungen hat, durch Trocknen der entwickelten Resistschicht, wodurch verhindert wird, daß der Entwickler aus dem organischen Lösungsmittel weiter in den Resistfilm eindringt.

2. Prozeß nach Anspruch 1, dadurch gekennzeichnet, daß das Resistmaterial ein strahlungsempfindliches Polymer ist, welche Entwicklung in jeder Entwicklungsstufe unterbrochen wird, bevor der Entwickler in der belichteten Resistschicht auf eine Tiefe vorgedrungen ist, die 1/3 der Dicke der Resistschicht beträgt.

3. Prozeß nach Anspruch 2, dadurch gekennzeichnet, daß das strahlungsempfindliche Polymer ausgewählt ist aus Polystyrol, Polysiloxan, Polyacrylat, Polymethacrylat, cyclisiertem Kautschuk, Polyvinylcinnamat, Polysulfon und anderen vernetzbaren Polymeren und Derivaten von ihnen.

4. Prozeß nach irgendeinem der Ansprüche 1 bis 3, dadurch gekennzeichnet, daß das Resistmaterial ein Negativresistmaterial ist, so daß ein Negativresistmuster gebildet wird.

5. Prozeß nach irgendeinem der Ansprüche 1 bis 3, dadurch gekennzeichnet, daß das Resistmaterial ein Positivresistmaterial ist, so daß ein Positivresistmuster gebildet wird.

6. Prozeß nach irgendeinem der Ansprüche 1 bis 5, dadurch gekennzeichnet, daß jede Entwicklungsstufe ferner das Spülen der mit Entwickler aus organischem Lösungsmittel entwickelten Resistschicht (11) mit einer flüssigen Spüllösung aus organischem Lösungsmittel vor dem Trocknen der entwickelten Resistschicht (11) umfaßt.

7. Prozeß nach irgendeinem der Ansprüche 1 bis 6, dadurch gekennzeichnet, daß wenigstens eine der Entwicklungsstufen unter Verwendung eines Systems ausgeführt wird, das eine Vielzahl von Düsen zum Anwenden des Entwicklers und einer flüssigen Spüllösung aus organischem Lösungsmittel auf die Resistschicht (11) enthält.

8. Prozeß nach irgendeinem der Ansprüche 1 bis 7, dadurch gekennzeichnet, daß bei dem Herstellungsschritt der Artikel unter Verwendung der gemusterten Resistschicht als Maske selektiv geätzt wird.

## Revendications

1. Un procédé pour la fabrication d'un dispositif à semiconducteurs, comprenant les étapes suivantes :
on revêt avec une matière de réserve un article (10) à fabriquer, pour former un revêtement de matière de réserve (11) sur l'article;
on expose le revêtement de matière de réserve (11) à un motif de rayonnement prédéterminé, pour former dans le revêtement de matière de réserve (11) une image latente correspondant au motif de rayonnement;
on développe avec un développateur consistant en un solvant organique le revêtement de matière de réserve (11) exposé, pour former sur l'article (10) un motif de matière de réserve correspondant au motif de rayonnement; et
on fabrique sélectivement l'article (10) en utilisant à titre de masque le motif de matière de réserve résultant,
dans lequel l'étape de développement est accomplie en au moins deux phases de développement, chaque phase de développement comprenant: le développement du revêtement de matière de réserve (11) exposé, avec un développateur consistant en un solvant organique; et l'interruption du développement lorsque le développateur consistant en un solvant organique a pénétré pratiquement dans une partie de surface du revêtement de matière de réserve exposé, en séchant le revêtement de matière de réserve développé, pour empêcher ainsi que le développateur consistant en un solvant organique ne pénètre plus profondément dans la pellicule de matière de réserve.

2. Un procédé selon la revendication 1, caractérisé en ce que la matière de réserve est un polymère sensible à un rayonnement, le développement étant interrompu à chaque phase de développement avant que le développateur n'ait pénétré dans le revêtement de matière de réserve exposé jusqu'à une profondeur qui est égale au tiers de l'épaisseur dL revêtement de matière de réserve.

3. Un procédé selon la revendication 2, caractérisé en ce que le polymère sensible un rayonnement est sélectionné parmi le polystytène, le polysiloxane, le polyacrylate, le polyméthacrylate, un caoutchouc cyclisé, le poly(cinnamate de vinyle), la polysulfone et d'autres polymère pouvant donner lieu à réticulation, et des dérivés de ceux-ci.

4. Un procédé selon l'une quelconque des revendications 1 à 3, caractérisé en ce que la matière de réserve est une matière de réserve négative, ce qui fait qu'un motif de matière de réserve négatif est formé.

5. Un procédé selon l'une quelconque des revendications 1 à 3, caractérisé en ce que la matière de réserve est une matière de réserve positive, ce qui fait qu'un motif de matière de réserve positif est formé.

6. Un procédé selon l'une quelconque des revendications 1 à 5, caractérisé en ce que chaque phase de développement comprend en outre le rinçage du revêtement de matière de réserve (11) développé, pour en éliminer le développateur consistant en un solvant organique, avec une solution de rinçage liquide consistant en un solvant organique, avant le séchage du revêtement de matière de réserve (11) développé.

7. Un procédé selon l'une quelconque des revendications 1 à 6, caractérisé en ce que l'une au moins des phases de développement est accomplie en utilisant un système comprenant de multiples buses pour appliquer au revêtement de matière de réserve (11) le développateur et une solution de rinçage liquide consistant en un solvant organique.

8. Un procédé selon l'une quelconque des revendications 1 à 7, caractérisé en ce que, dans l'étape de fabrication, l'article est attaqué sélectivement en utilisant à titre de masque le revêtement de matière de réserve dans lequel on a défini un motif.
